Europäisches Patentamt

European Patent Office

Office européen des brevets

(19)

(11) Publication number: **0 145 669**
A2

## (12) EUROPEAN PATENT APPLICATION

(21) Application number: **84830212.1**

(22) Date of filing: **13.07.84**

(51) Int. Cl.⁴: **H 03 J 9/04**

(30) Priority: **15.07.83 IT 4869383**

(43) Date of publication of application: **19.06.85**
**Bulletin 85/25**

(84) Designated Contracting States: **BE DE FR GB NL**

(71) Applicant: **AUTOVOX S.p.A., 981, via Salaria, I-00199 Roma (IT)**

(72) Inventor: **La Monaca, Camillo, via Silvani 118, I-Roma (IT)**
Inventor: **Menghini, Massimo, via Baldo degli Ubaldi 318, I-Roma (IT)**

(74) Representative: **Cavattoni, Massimo, STUDIO TECNICO BREVETTI MASSIMO CAVATTONI Via Archimede, 144, I-00197 Roma (IT)**

(54) Device for the control by voice of a signal receiver.

(57) A device for the voice control, particularly of the functions of the tuning in search and audio regulations in an electromagnetic signal receiver allows the user to interfere through his voice only and without a physical contact with the apparatus, on the usual regulations of the apparatus itself.

The device comprises a first microprocessor dedicated to the speech recognition and apt to receive the commands by the user through a microphone. The first microprocessor converts the analog signals received from the microphone into digital sampled signals and carries out the comparison between said samples obtained from the input and the samples which form the data table contained in its memory.

Each time a command is recognized, on its output pins an electric control appears, which is utilized by a second microprocessor, dedicated to the control of the electromagnetic signal receiver, in order to provide the control effects desired by the user.

A device for the voice control, particularly of the functions of the tuning in search and audio regulations in an electromagnetic signal receiver.

The present invention refers to a device for the voice control of the functions, for instance of tuning in search, and of the regulations, for instance of volume and tone, in an electromagnetic signal receiver, such as radioreceivers, television sets, car radios and the like.

Particularly, the invention refers to a device which allows the user to interfere, through his voice only and without a physical contact with the apparatus, on the usual regulations of the apparatus itself.

It is known that an electromagnetic or radioelectric signal receiver, such as for instance a radio receiver, can carry out a number of functions, in an original and effective way and with high reliability, when in its circuit structure the use of a suitably programmed microprocessor is provided for.

Microprocessor apparatuses are known, whose software carries out a number of functions, among which one can include: frequency synthesis; broadcasting station and frequency channel storing and re-establishing circuit feature verifying; digital type controls, such as tuning frequency displaying in digital form, in the form of broadcasting frequency value of the station or in the form of channel number; analog type controls, such as the volume and the tone and the like.

All the functions carried out by the microprocessor are usually started by means of mechanical controls, such as the keyboard, both of the electrical type and the mechanical type, or by means of remotely acted controls, such as remote controls and the like.

All these controls, on one hand, involve the willingness of the user, and, on the other hand, involve a mechanical action, usually accomplished by the use of the hands.

The need of a control device which does not involve a physical contact with the apparatus to control, but which utilizes the voice as the physical support of the control, is now beginning to be sensed: suffice it to think of the simplification in the use, for instance, of the car radio by means of a voice control system. In this way, the manoeuvre safety, offered to the motor vehicle driver, who desires to enjoy the delight of the music and of the broadcast bulletins, with particular reference to the ones related to the road traffic, is noticeably increased.

For such a purpose, it will be necessary the use of a device which is able to process, convert and interpret the voice command and attribute to it the feature of certainty in order to assure the recognition thereof.

The device of recognition of the voice and conversion of the speech into an electric signal, can be carried out in various ways.

The simplest and economically most convenient method is the one that the technology has already provided and which is known as voice recognition or speech recognition.

As it is known, such a method provides for the recognition of words or short sentences with an accuracy of about 90%, obviously treating them as electric signals, digitally sampled in advance and subsequently stored in the memory of a microprocessor, as complex information contents.

According to the present invention, this technique is refined and thrust to more sophisticated levels, till offering a noticeable service in various application fields, such as the radio and television set field, as well as in the already cited field of the car radio.

According to the present invention, a device for the voice control, particularly of the functions of the tuning in search and audio regulations in an electromagnetic signal receiver, is characterized in that it comprises a first microprocessor dedicated to the speech recognition and apt to receive the commands by the user through a microphone and to convert them into electric controls at its output pins, whereas a second microprocessor, dedicated to the control of the electromagnetic signal receiver, utilizes the electric controls present at said output pins of said first microprocessor in order to provide the control effects desired by the user.

In such a manner, one has the great advantage that the control of a car radio by means of a voice control device allows the user to control the apparatus without physical contact, i. e. without employing the hands, with a tremendous increase in the safety and practicalness.

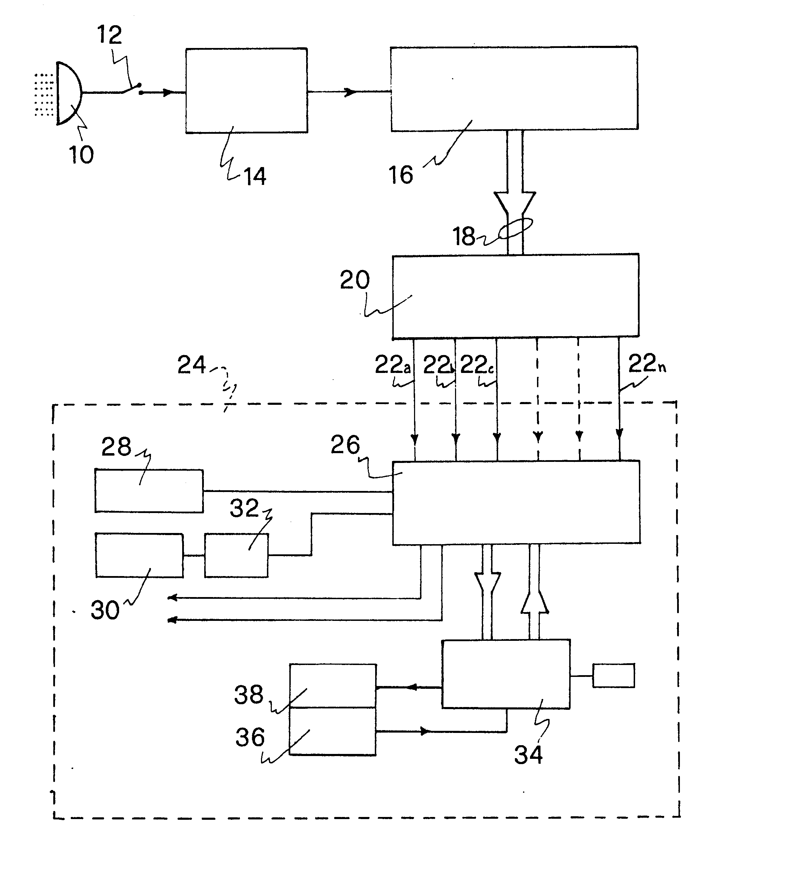

In the following, the present invention will be further clarified from the description of one form of practical embodiment of the device for the voice control of the functions of the tuning in search and audio regulations in electromagnetic signal receivers, description made in a purely illustrative and not limitative way, with reference to the accompanying drawing,

the single figure of which is a block diagram of the present device for the voice control, provided for the connection with a car radio, only the main blocks of which are shown, necessary for the description and the understanding of the operation of the device itself.

With reference to the accompanying block diagram, which represents a typical embodiment of the present device for the voice control in the car radio field, it is seen that it comprises a microphone 10, which is provided with a manually operable switch 12. The microphone 10 translates the voice commands, received by it in the form od sound waves, into analog electric signals, which, through a wide-band filter 14, having a pass-band in the order from about 300 to 7000 Hz, are sent to a first microprocessor 16.

The microprocessor 16 provides for processing the analog signals supplied at its input into digital sampled signals and for carrying out the comparison between these samples obtained from the input and the samples which form the data table in its memory.

In the case of recognition of a word or a short sentence, suitably digitized, the output lines 18 of the microprocessor 16 make up a matrix code, unambiguous and correlated with the recognized word or short sentence.

A digital combiner 20 processes the matrix code present on the output lines 18 of the microprocessor 16 and provides a change, permanent or not, of the logic state at one and only one of its output lines 22a, 22b, 22c, ..., 22n.

In other words, there exists a univocal correspondence between each word or short sentence contained into the vocabulary of the memory of the microprocessor 16 and the logic status of one of the output lines of the digital combiner 20, and each time one of the words or short sentences is sent to the microphone, the corresponding output line of the digital combiner 20 becomes active in a permanent or temporary way. Furthermore, the microprocessor 16 is programmed so as to recognize words or short sentences with an accuracy of about 90%.

The block 24 encloses a traditional radio circuit comprising a second microprocessor 26, which drives the various traditional blocks, such as the volume and tone regulation block 28, the blocks 30 and 32 for the electronic automatic and manual search and the phase-locked block 34, with its voltage-controlled oscillator block 36.

The output lines 22 of the digital combiner 20 represent the driving lines for the microprocessor 26 and the active status of one of them can or cannot be kept in time, upon the end of the voice command which has caused it, depending on the specific type of microprocessor used as the component 26 and depending on its software management. According to which one of the various lines has become active, the microprocessor 26 carries out all the functions and controls, pertinent to that input thereof, entrusted with it.

In the operation, let us suppose that the sentences stored into the data table of the microprocessor 16 are as follows:

"TUNING UP", upon the receipt of which the digital combiner 20 drives the pin of the microprocessor 26, relating to the electronic search of the station towards the higher frequencies of the range, active;

"TUNING DW", upon the receipt of which the digital combiner 20 drives the pin of the microprocessor 26, related to the electronic search of the station towards the lower frequencies of the range, active;

"STOP", upon the receipt of which the digital combiner 20 drives the pin of the microprocessor 26, relating to the stopping of the electronic search on the desired station, active;

"STORE", upon the receipt of which the digital combiner 20 drives the pin of the microprocessor 26, relating to the presetting for the storing of the station, active;

"1, 2, 3, ...", upon the receipt of which the digital combiner 20 drives the pin of the microprocessor 26, relating to the respective store location 1, 2, 3, ..., active: if the command had been preceded by the command "STORE", then the microprocessor 26 provides for the storing of the station being listened to into the store location 1, 2, 3, ...; if the command had not been preceded by the command "STORE", then the microprocessor 26 provides for the recall of the station contained in the store location 1, 2, 3, ...;

"VOLUME UP", upon the receipt of which the digital combiner 20 drives the pin of the microprocessor 26, relating to the increasing in the output power, active;

"VOLUME DW", upon the receipt of which the digital combiner 20 drives the pin of the microprocessor 26, relating to the decreasing in the output power, active;

"VOLUME STOP", upon the receipt of which the digital combiner 20 deenergizes the pins of the microprocessor 26, relating to the increasing and decreasing in the output power.

In this way, upon the receipt of the related voice command, at the microphone 10, the microprocessor 26 provides for the execution of the received command.

Therefore, the user who desires to modify the operation status of the car radio, first must operate the switch 12, provided for avoiding undesired operations by the device, and then pronounce before the microphone the word or short sentence relating to the desired new behaviour.

At once, the microprocessor 16 will detect the command and, through the digital combiner 20, will activate the corresponding pin of the microprocessor 26, carrying out the desired action.

Obviously, other words or short sentences and, or other commands may be provided for, and some of the hereinbefore listed ones may be lacking and, in a quite general way, the present device may be applied to any apparatus in which the univocal correspondence between the word or short sentence picked up by the microphone and the relating electric control can modify in a sequential and unambiguous way the control and command functions of the apparatus itself, and this with reference to any type of desired command or control.

Examples of apparatuses controllable by means of a device according to the present invention are, besides the car radios, the generic radio sets and the television receiving sets.

So far reference has been made to words or short sentences written into the memory of the microprocessor 16 on assembling, in an unerasable way, whereby the device commands are defined once and for all upon the manufacturing of the device.

Nevertheless, it may be provided that the microprocessor 16 carries out also the function of storing words or short sentences for their subsequent use as commands. According to this variation, the user chooses the sentences of his own liking and provides their storing into different memory location, depending on the control that later on he wishes to carry out by means of that word or short sentence.

After this initial presetting step, the subsequent operation of the device is similar to that of the already described type. Only in the case, in which the user wishes to change one, or more than one, of the command words or short sentences, then he will have to repeat the above described storing process. With this variation, the recognition with an accuracy up to 99% is made possible.

Although only one preferred embodiment of the present invention has been herein described and shown in detail, it is obvious that other numerous and different changes and modifications can be performed on it by the skilled in the art, without departing from the scope of the present invention. It is intended therefore that all these changes and modifications are encompassed in the field of this invention.

CLAIMS

1. A device for the voice control, particularly of the functions of the tuning in search and audio regulations in an electromagnetic signal receiver, which device is characterized in that it comprises a first microprocessor dedicated to the speech recognition and apt to receive the commands by the user through a microphone and to convert them into electric controls at its output pins, whereas a second microprocessor, dedicated to the control of the electromagnetic signal receiver, utilizes the electric controls present at said output pins of said first microprocessor in order to provide the control effects desired by the user.

2. A device according to claim 1, characterized in that said first microprocessor converts the analog signals received from said microphone into digital sampled signals and carries out a comparison between said samples obtained from the input and the samples which form the data table contained in its memory.

3. A device according to claim 1 or 2, characterized in that said first microprocessor, upon the recognition of a word or short sentence, suitably digitized, makes up, at its output pins, a matrix code, unambiguous and correlated with the recognized word or short sentence.

4. A device according to claim 3, characterized in that a digital combiner block is interposed between the output pins of said first microprocessor and the input pins of said second microprocessor, which carries out the logic state change on one and only one of its output lines depending on said matrix code present at its input pins.

5. A device according to any one of the preceding claims, characterized in that said microphone is connected to the input of said first microprocessor through an audio band-pass filter

6. A device according to claim 5, characterized in that said filter has a pass-band extending from about 300 to about 7000 Hz.

7. A device according to any one of the preceding claims, characterized in that said microphone can be inserted into the circuit by turning on a switch.

8. An electromagnetic signal receiver provided with a device for the voice control such as claimed in any one of the preceding claims.